# EUROPEAN PATENT APPLICATION

(11) **EP 4 685 064 A1**
(43) Date of publication of application: **28.01.2026**
(21) Application number: 24774682.9
(22) Date of filing: 06.03.2024
(51) Int. Cl.: B65D 1/00, C08F 10/02, H01L 21/304

(54) **POLYETHYLENE RESIN CONTAINER FOR HIGH-PURITY CHEMICAL**

(30) Priority: 22.03.2023 JP 2023045122; 04.10.2023 JP 2023173197
(71) Applicant: Tosoh Corporation, Yamaguchi 746-8501 (JP)
(72) Inventor: ISHIHARA, Hirotaka, Yokkaichi-shi, Mie 510-8540 (JP); YAMANO, Naoki, Yokkaichi-shi, Mie 510-8540 (JP)
(74) Representative: Novagraaf International SA
(86) International application number: PCT/JP2024/008513
(87) International publication number: WO 2024/195541

(57) **Abstract**

To provide a container for high purity chemicals made of a polyethylene resin, from which eluates derived from the polyethylene resin and elution of contaminants such as degraded substances into a chemical stored in the container are suppressed as far as possible. A container for high purity chemicals, which is made of a polyethylene resin, and the inner surface of which has a developed interfacial area ratio of 1.10 or less.

## Description

### TECHNICAL FIELD

The present invention relates to a container for high purity chemicals made of a polyethylene resin.

### BACKGROUND ART

In recent years, along with remarkable development in the field of electronics industry, demands for high purity chemicals are increasing. The high purity chemicals are used as chemicals inevitable for manufacturing large-scale integrated electronic circuits such as LSIs. Specifically, for wafer washing/etching, for wiring/insulating film etching, for washing jigs, for developing agents, for resist diluents, for resist stripping agents, for drying, etc., sulfuric acid, hydrochloric acid, nitric acid, hydrofluoric acid, ammonium fluoride, aqueous hydrogen peroxide, isopropyl alcohol, xylene, TMAH (tetramethylammonium hydroxide), methanol, acetic acid, phosphoric acid, aqueous ammonia, PGMEA (propylene glycol methyl ether acetate), DMSO (dimethyl sulfoxide), NMP (N-methyl-2-pyrrolidone), etc., have been used. As a material for 20 L or smaller containers for such high purity chemicals, for example 18 L containers, 4 L containers and 1 L containers, fluorinated resins and polyethylene resins are mainly used. Along with improvement of high integration of semiconductor circuits, demands for reduction of impurities and fine particles in the chemicals become stricter, and to meet such strict demands, demands for cleanness of containers storing such chemicals are also increasing year by year.

To overcome such problems, a method of using a specific tetrafluoroethylene-based copolymer may be mentioned. However, a tetrafluoroethylene-based copolymer is expensive (Patent Document 1).

Further, a container of which the amount of hydrocarbon-based solvent extracted and the content of low molecular weight components in a polyethylene resin are suppressed, and to which addition of an antioxidant, a neutralizing agent and a photo stabilizer is suppressed as far as possible, has been proposed. However, improvement in influence of an ash content by a catalyst component remaining in the polyethylene resin is insufficient, and measures to reduce the concentration of metal impurities eluted into the chemical have not yet been fully taken. Further, the sizes of the fine particles are at levels of 0.2 µm or larger, and the sizes of the fine particles have not yet been sufficiently reduced (Patent Documents 2, 3).

Further, a polyethylene for a container for high purity chemicals, having a density of 0.940 to 0.970 g/cm³, a melt flow rate at a temperature of 190°C under a load of 21.6 kg of 2 to 50 g/10 min, a ratio (Mw/Mn) of the weight average molecular weight (Mw) to the number average molecular wight (Mn) as obtained by gel permeation chromatography (GPC) of 8 to 15, and an ash content in a polyethylene resin of 50 ppm or less, and a container for high purity chemicals, have been proposed. However, improvement in influence of the ash content by a catalyst component remaining in the polyethylene resin is insufficient, and measures to reduce the concentration of metal impurities eluted into the chemical have not yet been fully taken (Patent Document 4).

Still further, a polyethylene resin for a polyethylene resin for a container for ultrahigh purity chemicals having a density of 0.940 to 0.970 g/cm³, a melt flow rate at a temperature of 190°C under a load of 21.6 kg of 2 to 8.5 g/10 min, a ratio (Mw/Mn) of the weight average molecular weight (Mw) to the number average molecular wight (Mn) as obtained by gel permeation chromatography (GPC) of 8 to 15, a proportion of components with a molecular weight of 1000 or less of 0.30 wt% or less in a molecular weight distribution curve as obtained by GPC, and ESCR (environmental stress cracking resistance) of 130 hours or more, and a container for high purity chemicals, have been proposed. However, when such a polyethylene resin is formed into a small-sized container, the container is insufficient in surface smoothness (Patent Document 5).

### PRIOR ART DOCUMENTS

### PATENT DOCUMENTS

Patent Document 1: WO2000/17057
Patent Document 2: JP-A-H7-62161
Patent Document 3: JP-A-H7-257540
Patent Document 4: JP-A-H11-80257
Patent Document 5: Japanese Patent No. 6705157

### DISCLOSURE OF INVENTION

### TECHNICAL PROBLEM

It is an object of the present invention to provide a container for high purity chemicals from which eluates from a polyethylene resin and elution of contaminants such as degraded substances can be suppressed as far as possible.

### SOLUTION TO PROBLEM

The present inventors have conducted extensive studies to achieve the above object and as a result found that a container made of a polyethylene resin, the inner surface of which has a specific developed interfacial area ratio, can be a container for high purity chemicals with little fine particles derived from the polyethylene and little metal impurities derived from a polymerization catalyst component, and accomplished the present invention.

That is, embodiments of the present invention are the following [1] to [7].

[1] A container for high purity chemicals, which is made of a polyethylene resin, and an inner surface of which has a developed interfacial area ratio of 1.10 or less.
[2] The container for high purity chemicals according to [1], wherein the inner surface has a maximum roughness Rz of 10.0 µm or less.
[3] The container for high purity chemicals according to [1] or [2], wherein the inner surface has a gloss of 40% or more.
[4] The container for high purity chemicals according to any one of [1] to [3], wherein a number of fine particles determined as follows is 10 particles/mL or less:
   the container which has not been washed is filled with ultrapure water and stored at rest at 40°C for 35 days, and the number of fine particles having a particle size of 0.1 µm or more eluted from the container after the storage is counted.
[5] The container for high purity chemicals according to any one of [1] to [4], wherein the polyethylene resin has a melt flow rate at a temperature of 190°C under a load of 21.6 kg (hereinafter referred to as HLMFR) of 21 to 80 g/10 min and a ratio (Mw/Mn) of a weight average molecular weight (Mw) to a number average molecular weight (Mn) as obtained by gel permeation chromatography (GPC) of 5.0 to 7.9.
[6] The container for high purity chemicals according to [5], wherein the polyethylene resin has the following properties (1) to (5):
   (1) a density (JIS K6922-1) of 0.945 to 0.955 g/cm³;
   (2) a melt flow rate at 190°C under a load of 2.16 kg (hereinafter referred to as MFR) of 0.5 to 1.5 g/10 min;
   (3) in a molecular weight distribution curve obtained by GPC, a proportion of components with a molecular weight of 1000 or less of 0.30 wt% or less;
   (4) a metal content of 15 ppm or less to the polyethylene resin; and
   (5) an environmental stress cracking resistance (ESCR) of 100 hours or longer.
[7] The container for high purity chemicals according to [5] of [6], wherein the polyethylene resin contains two components of a low molecular weight ethylene-based polymer having a MFR (melt flow rate at 190°C under a load of 2.16 kg) of 20 to 40 g/10 min and a density (JIS K6922-1) of 0.960 to 0.970 g/cm³, and a high molecular weight ethylene-based polymer having a HLMFR at 190°C under a load of 21.6 kg of 0.10 to 10 g/10 min and a density (JIS K6922-1) of 0.920 to 0.940 g/cm³, in a weight ratio of the two components (low molecular weight ethylene-based polymer: high molecular weight ethylene-based polymer) of 40:60 to 60:40.

### ADVANTAGEOUS EFFECTS OF INVENTION

According to the present invention, it is possible to provide a container for high purity chemicals with little fine particles derived from a polyethylene resin and metal impurities derived from a polymerization catalyst component. It is also possible to provide a container for high purity chemicals particularly suitable for a small-sized container of 20 L or smaller, from which fine particle components are less likely to be eluted into a chemical in the container, and from which the amount of fine particles eluted is small even after long-term storage.

### DESCRIPTION OF EMBODIMENTS

According to an embodiment of the present invention, the container for high purity chemicals is a container for high purity chemicals, which is made of a polyethylene resin, and the inner surface of which has a developed interfacial area ratio of 1.10 or less, and the inner surface has a developed interfacial area ratio of preferably 1.06 or less. When the developed interfacial area ratio of the inner surface is 1.06 or less, fine particles derived from the polyethylene resin and metal impurities derived from a polymerization catalyst component eluted into a high purity chemical stored in the container tend to be small, and such a container is suitable for storage of a high purity chemical. The developed interfacial area ratio means a ratio of the surface area to the area (surface area/area), and if the developed interfacial area ratio of a container is more than 1.10, the liquid contact area with a high purity chemical liquid stored in the container increases and elution of fine particles derived from the polyethylene resin increases, and such a container is not suitable as a container for high purity chemicals.

The maximum roughness Rz of the inner surface of the container for high purity chemicals is preferably 10.0 µm or less, more preferably 5.0 µm or less. When Rz is 10.0 µm or less, the container is excellent in appearance. Further, bubbles in the chemical will not stay at a roughed portion and will not be detected as fine particles, and thus the number of fine particles does not increase. Rz is the sum of the maximum peak height and the maximum valley depth in a roughness curve in a sampling length.

The gloss of the inner surface of the container for high purity chemicals is preferably 40% or more, more preferably 50% or more, whereby the container tends to have favorable glossiness, excellent surface smoothness and excellent bubble removability from the chemical.

The high purity chemical means a chemical with low contents of metals and fine particles, used in wafer washing step, an etching step, etc. in semiconductor production process. The high purity chemical may, for example, be ultrapure water, aqueous hydrogen peroxide, sulfuric acid, nitric acid, hydrochloric acid, hydrofluoric acid, aqueous ammonia, a CMP slurry or a photoresist liquid.

The container for high purity chemicals is suitably a small sized container having an inner area of 5000 cm² or less, and may, for example, be a container having an internal capacity of 10 mL to 20 L.

The container may have any shape so long as it can contain and store the high purity chemical, and may, for example, be cylindrical or box-shape.

The container may be a single-layered container made of a single polyethylene resin, a multi-layered container having different polyethylene resins laminated, or a multi-layered container having a polyethylene resin and a resin other than the polyethylene resin laminated. For example, in order to improve high purity chemical barrier properties and the strength of the container, the container may be a multi-layered container composed of the polyethylene resin as an inner layer, at least one resin selected from an ethylene/vinyl alcohol copolymer, a polyvinyl alcohol resin, a polyamide resin and a recycled polyethylene resin as an interlayer, and an outer layer strengthened by the polyethylene resin, FRP or the like having drop impact resistance.

Further, in order that the container for high purity chemicals is a container suitable for containing and storing the high purity chemical, the number of fine particles determined as follows is 10 particles/mL or less. The container which has not been washed is filled with ultrapure water and stored at rest at 40°C for 35 days, and the number of fine particles having a particle size of 0.1 µm or more eluted from the container after the storage is counted. When the number of fine particles having a particle size of 0.1 µm or more is 10 particles/mL or less, even a small-sized container is adaptable to LSI miniaturization.

The polyethylene resin for the container for high purity chemicals has a HLMFR (JIS K6922-1) of preferably 21 to 80 g/10 min, more preferably 30 to 60 g/10 min, whereby it is excellent in moldability and provides a container having an excellent surface smoothness.

The polyethylene resin for the container for high purity chemicals has a ratio of Mw to Mn, that is Mw/Mn, as obtained by GPC of preferably 5.0 to 7.9, more preferably 6.0 to 7.7, whereby it is excellent in chemical resistance and provides a container having an excellent surface smoothness.

The polyethylene resin for the container for high purity chemicals has a density (JIS K6922-1) of preferably 0.945 to 0.955 g/cm³, more preferably 0.947 to 0.952 g/cm³, whereby it provides a container from which elution of fine particles is little and which is excellent in chemical resistance.

The polyethylene resin for the container for high purity chemicals has a MFR (JIS K6922-1) at 190°C under a load of 2.16 kg of preferably 0.5 to 1.5 g/10 min, more preferably 0.8 to 1.2 g/10 min, whereby it is especially excellent in moldability and provides a container excellent in surface smoothness.

The polyethylene resin for the container for high purity chemicals has a proportion of components with a molecular weight of 1000 or less of 0.30 wt% or less, more preferably 0.25 wt% or less, in a molecular weight distribution curve obtained by GPC, whereby it provides a container from which elution of fine particles is especially little.

The polyethylene resin for the container for high purity chemicals has a metal content to the polyethylene resin of preferably 15 ppm or less, more preferably 10 ppm, whereby it provides a container from which elution of metals is especially little. The metal content is the ratio of metal components to the total resin represented by weight ppm, and the metal content corresponds to a residue of e.g. Mg, Al and Ti obtained by incinerating the resin, followed by alkali fusion.

The polyethylene resin for the container for high purity chemicals has an ESCR of preferably 100 hours or more, whereby it provides a container especially excellent in chemical resistance.

The polyethylene resin for the container for high purity chemicals may be produced using a high activity catalyst such as a Ziegler catalyst or a metallocene catalyst. For example, it may suitably be produced by polymerizing ethylene or copolymerizing ethylene and a C₃₋₂₀ α-olefine in a ratio to achieve a desired density, using as a polymerization catalyst a high activity Ziegler catalyst composed of a transition metal compound such as titanium or zirconium, a magnesium compound and an organic aluminum compound.

As the catalyst, catalysts described in Japanese Patent No. 3319051 may be mentioned.

The C₃₋₂₀ α-olefine may, for example, be propylene, 1-butene, 4-methyl-1-pentene, 3-methyl-1-butene, 1-pentene, 1-hexene, 1-heptene, 1-octene, 1-nonene, 1-decene, 1-undecene, 1-dodecene, 1-tridecene, 1-tetradecene, 1-pentadecene, 1-hexadecene, 1-heptadecene, 1-octadecene, 1-nonadecene or 1-eicosene.

The polymerization method in production of the polyethylene resin for the container for high purity chemicals is, in order to suppress the concentration of metal impurities to be eluted into the chemical and to prevent inclusion of low molecular weight polymers which may cause generation of fine particles, into the resin, preferably slurry polymerization using a polymerization solvent having 6 or more and 10 or less carbon atoms, such as n-hexane or n-heptane, to produce two components that is a low molecular weight ethylene-based polymer having a MFR of 20 to 40 g/10 min and a density of 0.960 to 0.970 g/cm³, and a high molecular weight ethylene-based polymer having a HLMFR of 0.1 to 10 g/10 min and a density of 0.920 to 0.940 g/cm³, in a weight ratio of the two components of 40:60 to 60:40. The low molecular weight component and the high molecular weight component may be produced for example by two step polymerization method.

Further, the polyethylene resin for the container for high purity chemicals contains preferably none of additives such as an antioxidant, a photo stabilizer and a neutralizing agent, whereby it provide a container with little metal contaminants.

The container for high purity chemicals may be obtained by forming the polyethylene resin having the specific properties into a container shape e.g. by direct blow molding, injection molding or injection blow molding. Particularly by a blow molding method using a direct blow molding machine installed in a clean room and using as a blowing air an air from which fine particle are removed by a filter, it is possible to produce a clean container.

### EXAMPLES

Now, the present invention will be described in further detail with reference to Examples. However, it should be understood that the present invention is by no means restricted thereto. Test methods in Examples and Comparative Examples are as follows.

### (1) Developed interfacial area ratio of container inner surface

A container obtained by blow molding the polyethylene resin, having an internal capacity of 800 mL or 500 mL was used. The surface area and the area of the inner surface of the body of the container were measured by a surface profiler laser microscope (manufactured by KEYENCE CORPORATION, VK-X200) to calculate the developed interfacial area ratio (surface area/area).

### (2) Maximum roughness Rz of container inner surface

The maximum roughness Rz of the inner surface of the body of the container was measured by a surface profiler laser microscope (manufactured by KEYENCE CORPORATION, VK-X200)

### (3) Gloss of container inner surface

The gloss of the inner surface of the body of the container at an angle of incidence of 60° was measured by a variable angle photometer (manufactured by NIPPON DENSHOKU, 300A).

### (4) Number of fine particles

In a clean room at 23°C, the container which had not been washed was filled with ultrapure water to 80% of the internal capacity, lidded and shaken 15 times, and left at rest in a clean oven (manufactured by Yamato Scientific Co., Ltd., DE411) set at 40°C for 35 days. Then, the number of fine particles having a particle size of 0.1 µm or more in the ultrapure water stored in the container was measured by a particle counter (manufactured by RION Co., Ltd., controller: KE-40B1, particle sensor: KS-42A). The number of fine particles in the ultrapure water is represented by particles/mL.

### (5) HLMFR

Measured in accordance with JIS K6922-1 at 190°C under a load of 21.6 kg.

### (6) Mw/Mn

Measured by GPC using HLC-8321GPC/HT manufactured by Tosoh Corporation (columns: TSKgel guardcolumn HHR and TSKgel GMHHR-H, manufactured by Tosoh Corporation) and using 1,2,4-trichlorobenzene as an eluent. The analytical curve of the molecular weight was calibrated using a polystyrene sample having a known molecular weight.

### (7) Density

Measured in accordance with JIS K6922-1 by density gradient tube method.

### (8) MFR

Measured in accordance with JIS K6922-1 at 190°C under a load of 2.16 kg.

### (9) Components with molecular weight of 1000 or less

From a molecular weight distribution curve obtained by GPC measurement, the proportion of an integrated amount of components with a molecular weight of 1000 or less was calculated.

### (10) Metal content

The polyethylene resin was incinerated and subjected to alkali fusion to be formed into a solution, which was used as a measurement solution. The metal content in the measurement solution sample was measured using Optima 8300 by ICP-AES measurement.

### (11) Environmental stress cracking resistance (ESCR)

In accordance with JIS K6922-2, a test specimen was dipped in a nonionic surfactant (10 wt% aqueous solution) of 50°C, and a time at which the test specimen broke with a probability of 50% (F50 value) was measured.

### (12) Blow molding

Using a direct blow molding machine MSE-50E/54M-A (manufactured by Tahara Machinery Ltd.) having an extrusion screw with a diameter of 50 mm, at a cylinder temperature of 190 to 200°C at a number of screw revolutions of 10 to 18 revolutions, a parison was continuously extruded from the tip of the die, to form a container having an average thickness of 1 mm and an internal capacity of 800 mL (inner surface area: 560 cm²) or 500 mL (inner surface area: 420 cm²).

### Example 1

### <Preparation of solid catalyst component>

Into a 3 L glass flask equipped with a stirring apparatus, 30.0 g (1.23 mol) of a metal magnesium power and 168.0 g (0.494 mol) of titanium tetrabutoxide were put, and 192 g (2.59 mol) of n-butanol having 1.5 g of iodine dissolved therein was added at 90°C over a period of 2 hours, followed by stirring under a nitrogen atmosphere at 140°C for 2 hours while generated hydrogen gas was discharged. The glass flask was heated to 110°C, 26 g (0.125 mol) of tetraethoxysilane and 19 g (0.125 mol) of tetramethoxysilane were added, followed by stirring at 140°C further for 2 hours. Then, 2.1 liter of hexane was added to obtain a uniform solution.

The uniform solution was put in a 10 L stainless steel autoclave equipped with a stirring apparatus, and while the temperature in the autoclave was kept at 45°C, 800 mL of a hexane solution containing 1.0 mol of diethyl aluminum chloride and 0.5 mol of i-butyl aluminum dichloride was added over a period of 1 hour, followed by stirring at 60°C further for 1 hour to generate particles. The temperature was decreased to 45°C again, and 1.04 kg (3.35 mol) of a 50% hexane solution was added over a period of 2 hours. After the entire solution was added, the mixture was stirred at 60°C for 1 hour to obtain a solid catalyst component. The obtained solid catalyst component, after removing remaining unreacted products and by-products with hexane, was used as a hexane slurry for production of the polyethylene resin.

### <Production of polyethylene A >

While dehydrated and purified hexane at 110 L/hour, 110 mmol of tributyl aluminum as an organic aluminum compound, a solid catalyst component at 0.4 g/hour, ethylene at 25.4 kg/hour, and hydrogen at a ratio to ethylene concentration of 0.45 mol/mol were supplied into a first reactor having an internal capacity of 370 L of a continuous polymerization vessel, first step ethylene polymerization (low molecular weight component) was continuously conducted at a temperature of 85°C under a total pressure of 30 kg/cm² for an average retention time of 3.4 hours. The low molecular weight component had a MFR of 35 g/10 min and a density of 0.968 g/cm³.

From a hexane slurry containing the first step polymer, unreacted hydrogen and ethylene were removed in a flush tank, and then the hexane slurry was introduced into a second step polymerization reactor having an internal capacity of 545 L. While additional hexane was supplied at 45 L/hour, ethylene at 21.5 kg/hour, 1-butene at 1.9 kg/hour, and hydrogen at a ratio to ethylene concentration of 0.016 mol/mol were supplied to the polymerization reactor, ethylene polymerization (high molecular weight component) was conducted at a temperature of 80°C under a total pressure of 20 kPa/cm² for an average retention time of 3.3 hours. The high molecular weight component had a HLMFR of 2.2 g/10 min and a density of 0.930 g/cm³. From a product discharged from the second polymerization reactor, unreacted hydrogen, ethylene and 1-butene were removed in a flush tank, and the product was washed with hexane at 50 L/hour and subjected to a drying step, to obtain an ethylene-based copolymer mixture powder. The proportion of the low molecular weight component was 55 wt% and the proportion of the high molecular weight component was 45 wt%. The powder obtained by the above two step polymerization, was pelletized without adding an additive to obtain polyethylene A. The results of measurement of physical properties are shown in Table 1.

A 800 mL container was formed by using the polyethylene A, and of the obtained container, the developed interfacial area ratio, the maximum roughness Rz and the gloss of the container inner surface and the number of fine particles were measured. The results are shown in Table 1.

### Example 2

A 500 mL container was formed by using the same polyethylene A as in Example 1, and of the obtained container, the developed interfacial area ratio, the maximum roughness Rz and the gloss of the container inner surface and the number of fine particles were measured. The results are shown in Table 1.

### Example 3

### <Production of polyethylene B>

In the same manner as in Example 1 except that hydrogen at a ratio to ethylene concentration of 0.40 mol/mol was supplied to the first step polymerization reactor and that 1-butene at 2.5 kg/hour and hydrogen at a ratio to ethylene concentration of 0.020 mol/mol were supplied to the second step polymerization reactor, ethylene and butene-1 were copolymerized in hexane by two step polymerization method to obtain a polymer powder. The low molecular weight component of the first step polymerization reactor had a MFR of 27 g/10 min and a density of 0.967 g/cm³, and the high molecular weight component of the second step polymerization reactor had a HLMFR of 3.2 g/10 min and a density of 0.928 g/cm³. The powder obtained by the two step polymerization was pelletized without adding an additive to obtain polyethylene B. The results of measurement of physical properties are shown in Table 1.

A 800 mL container was formed by using the polyethylene B, and of the obtained container, the developed interfacial area ratio, the maximum roughness Rz and the gloss of the container inner surface and the number of fine particles were measured. The results are shown in Table 1.

### Comparative Example 1

### <Production of polyethylene C >

In the same manner as in Example 1 except that hydrogen at a ratio to ethylene concentration of 0.25 mol/mol was supplied to the first step polymerization reactor and that hydrogen at a ratio to ethylene concentration of 0.050 mol/mol was supplied to the second step polymerization reactor, ethylene and butene-1 were copolymerized in hexane by two step polymerization method to obtain a polymer powder.

The low molecular weight component of the first step polymerization reactor had a MFR of 18 g/10 min and a density of 0.967 g/cm³, and the high molecular weight component of the second step polymerization reactor had a HLMFR of 8.5 g/10 min and a density of 0.932 g/cm³. The powder obtained by the two step polymerization was pelletized without adding an additive to obtain polyethylene C. The results of measurement of physical properties are shown in Table 1.

A 800 mL container was formed by using the polyethylene C, and of the obtained container, the developed interfacial area ratio, the maximum roughness Rz and the gloss of the container inner surface and the number of fine particles were measured. The results are shown in Table 1.

### Comparative Example 2

### <Production of polyethylene D>

In the same manner as in Example 1 except that hydrogen at a ratio to ethylene concentration of 0.70 mol/mol was supplied to the first step polymerization reactor and that hydrogen at a ratio to ethylene concentration of 0.010 mol/mol was supplied to the second step polymerization reactor, ethylene and butene-1 were copolymerized in hexane by two step polymerization method to obtain a polymer powder.

The low molecular weight component of the first step polymerization reactor had a MFR of 50 g/10 min and a density of 0.969 g/cm³, and the high molecular weight component of the second step polymerization reactor had a HLMFR of 1.4 g/10 min and a density of 0.927 g/cm³. The powder obtained by the two step polymerization was pelletized without adding an additive to obtain polyethylene D. The results of measurement of physical properties are shown in Table 1.

A 800 mL container was formed by using the polyethylene D, and of the obtained container, evaluation of the container inner surface and measurement of the fine particles were conducted. The results are shown in Table 1.

### Comparative Example 3

A 500 mL container was formed by using the same polyethylene D as in Comparative Example 2, and of the obtained container, the developed interfacial area ratio, the maximum roughness Rz, the gloss and the number of fine particles were measured. The results are shown in Table 1.

### Comparative Example 4

The following commercial high density polyethylene was used as polyethylene E.

Nipolon Hard (tradename) 8022 manufactured by Tosoh Corporation (MFR: 0.35 g/10 min, density: 0.958 g/cm³, no additive added)

A 800 mL container was formed by using the polyethylene E, and of the obtained container, evaluation of the container inner surface and measurement of the number of fine particles were conducted. The results of the evaluation of physical properties of the resin and the container are shown in Table 1.

### Comparative Example 5

The following commercial high density polyethylene was used as polyethylene F.

Nipolon Hard (tradename) 8D01A manufactured by Tosoh Corporation (MFR: 0.05 g/10 min, density: 0.957 g/cm³, no additive added)

A 800 mL container was formed by using the polyethylene F, and of the obtained container, the developed interfacial area ratio, the maximum roughness Rz and the gloss of the container inner surface and the number of fine particles were measured. The results of the evaluation of physical properties of the resin and the container are shown in Table 1.

**Table 1**

| | | Unit | Ex. 1 | Ex. 2 | Ex. 3 | Comp. Ex. 1 | Comp. Ex. 2 | Comp. Ex. 3 | Comp. Ex. 4 | Comp. Ex. 5 |
|---|---|---|---|---|---|---|---|---|---|---|
| Physical properties of container inner surface | Developed interfacial area ratio | - | 1.01 | 1.03 | 1.06 | 1.52 | 1.15 | 1.23 | 1.31 | 1.33 |
| | Rz | µm | 3.7 | 4.1 | 3.8 | 18.2 | 9.6 | 10.3 | 11.2 | 12.1 |
| | Gloss | % | 55 | 52 | 57 | 35 | 23 | 20 | 11 | 12 |
| | Number of fine particles of 0.1 µm or more | particles/ mL | 5.7 | 7.1 | 6.4 | 18 | 12 | 15 | 25 | 18 |
| Physical properties of resin | Polyethylene resin | - | A | A | B | C | D | D | E | F |
| | HLMFR | g/10 min | 40 | 40 | 45 | 55 | 30 | 30 | 25 | 8.0 |
| | Mw/Mn | - | 7.6 | 7.6 | 6.2 | 4.6 | 9.2 | 9.2 | 10 | 14 |
| | Density | g/cm³ | 0.951 | 0.951 | 0.949 | 0.952 | 0.950 | 0.950 | 0.958 | 0.957 |
| | MFR | g/10 min | 0.80 | 0.80 | 1.2 | 1.6 | 0.40 | 0.40 | 0.35 | 0.05 |
| | Proportion of components with molecular weight of 1000 or less | wt% | 0.25 | 0.25 | 0.22 | 0.16 | 0.38 | 0.38 | 0.40 | 0.27 |
| | Metal content | PPM | 7 | 7 | 8 | 7 | 7 | 7 | 10 | 9 |
| | ESCR | hour | 200 | 200 | 150 | 90 | >500 | >500 | 80 | 160 |

The entire disclosures of Japanese Patent Application No. 2023-045122 filed on March 22, 2023 and Japanese Patent Application No. 2023-173197 filed on October 4, 2023 including specifications, claims and summaries are incorporated herein by reference in their entireties.

## Claims

1. A container for high purity chemicals, which is made of a polyethylene resin, and an inner surface of which has a developed interfacial area ratio of 1.10 or less.

2. The container for high purity chemicals according to Claim 1, wherein the inner surface has a maximum roughness Rz of 10.0 µm or less.

3. The container for high purity chemicals according to Claim 1, wherein the inner surface has a gloss of 40% or more.

4. The container for high purity chemicals according to Claim 1, wherein a number of fine particles determined as follows is 10 particles/mL or less:
the container which has not been washed is filled with ultrapure water and stored at rest at 40°C for 35 days, and the number of fine particles having a particle size of 0.1 µm or more eluted from the container after the storage is counted.

5. The container for high purity chemicals according to Claim 1, wherein the polyethylene resin has a melt flow rate at a temperature of 190°C under a load of 21.6 kg (hereinafter referred to as HLMFR) of 21 to 80 g/10 min and a ratio (Mw/Mn) of a weight average molecular weight (Mw) to a number average molecular weight (Mn) as obtained by gel permeation chromatography (GPC) of 5.0 to 7.9.

6. The container for high purity chemicals according to Claim 5, wherein the polyethylene resin has the following properties (1) to (5):
(1) a density (JIS K6922-1) of 0.945 to 0.955 g/cm³;
(2) a melt flow rate at 190°C under a load of 2.16 kg (hereinafter referred to as MFR) of 0.5 to 1.5 g/10 min;
(3) in a molecular weight distribution curve obtained by GPC, a proportion of components with a molecular weight of 1000 or less of 0.30 wt% or less;
(4) a metal content of 15 ppm or less to the polyethylene resin; and
(5) an environmental stress cracking resistance (ESCR) of 100 hours or longer.

7. The container for high purity chemicals according to Claim 5, wherein the polyethylene resin contains two components of a low molecular weight ethylene-based polymer having a MFR (melt flow rate at 190°C under a load of 2.16 kg) of 20 to 40 g/10 min and a density (JIS K6922-1) of 0.960 to 0.970 g/cm³, and a high molecular weight ethylene-based polymer having a HLMFR of 0.10 to 10 g/10 min and a density (JIS K6922-1) of 0.920 to 0.940 g/cm³, in a weight ratio of the two components (low molecular weight ethylene-based polymer: high molecular weight ethylene-based polymer) of 40:60 to 60:40.
